# EUROPÄISCHE PATENTSCHRIFT

(11) **EP 2 587 271 B1**
(45) Veröffentlichungstag und Bekanntmachung des Hinweises auf die Patenterteilung: **07.07.2021**
(21) Anmeldenummer: 12005404.4
(22) Anmeldetag: 25.07.2012
(51) Int. Cl.: G01R 31/50, G01R 31/14, G01R 31/58

(54) **Prüfvorrichtung von Kabeln zur Spannungsprüfung durch eine VLF-Spannung**
Testing apparatus for cables for voltage testing by means of a VLF voltage
Dispositif de contrôle de câbles destiné à contrôler la tension au moyen d'une tension VLF

(30) Priorität: 27.10.2011 DE 102011117491
(43) Veröffentlichungstag der Anmeldung: 01.05.2013
(73) Patentinhaber: Megger Germany GmbH, 96148 Baunach (DE)
(72) Erfinder: Scheuschner, Sven, 01471 Radeburg (DE); Stechemesser, Nico, 01067 Dresden (DE); Bechler, Dirk, 01129 Dresden (DE); Gramsch, Christoph, 01307 Dresden (DE); Berth, Torsten, 01468 Moritzburg (DE)
(74) Vertreter: Marschall, Stefan

(56) Entgegenhaltungen:
- EP-A2- 1 191 341
- DE-A1- 4 419 145
- DE-A1- 10 206 788
- DE-A1- 19 606 996
- DE-C2- 3 629 352

## Beschreibung

Die Erfindung bezieht sich auf eine Prüfvorrichtung von Kabeln mit einer VLF-Spannung zur Generierung einer kosinus-rechteckförmigen Prüfspannung, wobei eine Gleichspannungsquelle das Kabel auf eine Spannung auflädt und das geladene Kabel über steuerbare Schaltelemente auf eine Gegenpolarität umschwingt sowie in einer weiteren Schaltstellung das Kabel auf die ursprüngliche Polarität zurückschwingt.

Es sind verschiedene Schaltungsanordnungen für die Generierung einer VLF-Prüfungsspannung zur Prüfung, insbesondere von Mittelspannungskabeln, bekannt. So wird eine Schaltungsanordnung zur Generierung einer cos-rechteckförmigen Prüfungsspannung in der DE 36 29 352 CI aufgezeigt. Der Vorteil dieser Anordnung ist, dass sich in der Umschwingphase eine der Netzfrequenz vergleichbare Belastung du/dt für das zu prüfende Kabel ergibt. Nachteilig dieser Schaltungsanordnung ist, dass ein rotierender elektromechanischer Schalter sehr verschleißbehaftet ist, dass sich durch die Kompensation der Umschwingverluste nur in der negativen Phase eine asymmetrische Kabelbelastung ergibt, dass ein Hochspannungs-Stützkondensator für kleine Prüfleistungen erforderlich ist.

Ferner wird in der DE 195 13 441 A eine Schaltungsanordnung beschrieben, welche ebenfalls die Generierung einer VLF-Prüfungsspannung aufzeigt. Weiterhin sind aus der DE 37 00 647 A, DE 37 37 373 A, DE 38 05 733 A ebenfalls Schaltungsanordnungen zur Isolationsprüfung bekannt geworden.

Bei diesen bekannten Anordnungen wird eine Prüfungsspannung zur Generierung von sinusförmigen Spannungen eingesetzt. Nachteilig hierbei ist es, dass durch das Prinzip bei der Prüfung in das Kabel eine im Quadranten 1 und 3 eines Spannungsverlaufes eingeprägte Energie in der jeweiligen Entladephase in 2 und 4 Quadranten dem Prüfling wieder entzogen und in Wärme umgewandelt werden muss. Somit ergibt sich ein schlechter Wirkungsgrad der Anlage, welcher die realisierbare Prüfleistung limitiert.

Aufgabe der Erfindung ist es, eine einfache Prüfvorrichtung der gattungsgemäßen Art zu schaffen, die eine kompakte Bauform mit hoher Prüfleistung zulässt.

Die Lösung dieser Aufgabe erfolgt erfindungsgemäß durch die Merkmale des Anspruchs 1.

Alternativ wird eine Prüfvorrichtung nach dem Anspruch 2 vorgeschlagen.

Der Vorteil ist, dass kein volumen-/kostenintensiver Stützkondensator erforderlich ist. Durch diese Anordnungen ist bei kurzen Kabeln mit geringen kapazitiven Lasten eine direkte Speicherung möglich, wobei die zugeordnete Drossel nicht einschaltbar ist. Sind Kabel mit einer höheren Kapazität zu prüfen, bei denen durch die begrenzte Leistung der Gleichspannungsquelle das Verhältnis du/dt einen definierten Anstieg unterschreitet, wird die Drossel als Energiespeicher eingeschaltet.

Eine vorteilhafte Ausbildung besteht darin, dass das Schaltelement als bipolarer Halbleiterschalter ausgebildet ist.

Um die Übergangsphasen vorteilhaft zu gestalten ist gegebenenfalls vorgesehen, dass über die Mess- und Steuereinheit in einer Umschaltphase die Spannung der Gleichstromquelle absenkbar ist.

In der Zeichnung sind Ausführungsbeispiele der Erfindung schematisch dargestellt. Es zeigen:
- Fig. 1: eine Prüfeinrichtung mit einer Gleichspannungsquelle;
- Fig. 2: eine Darstellung einer Spannungstransformation;
- Fig. 3: eine alternative Prüfeinrichtung mit zwei Gleichspannungsquellen, und
- Fig. 4: eine Ausbildung einer Prüfeinrichtung gemäß Fig. 1 mit einer Mittelspeisung zwischen Drossel und Schaltelement.

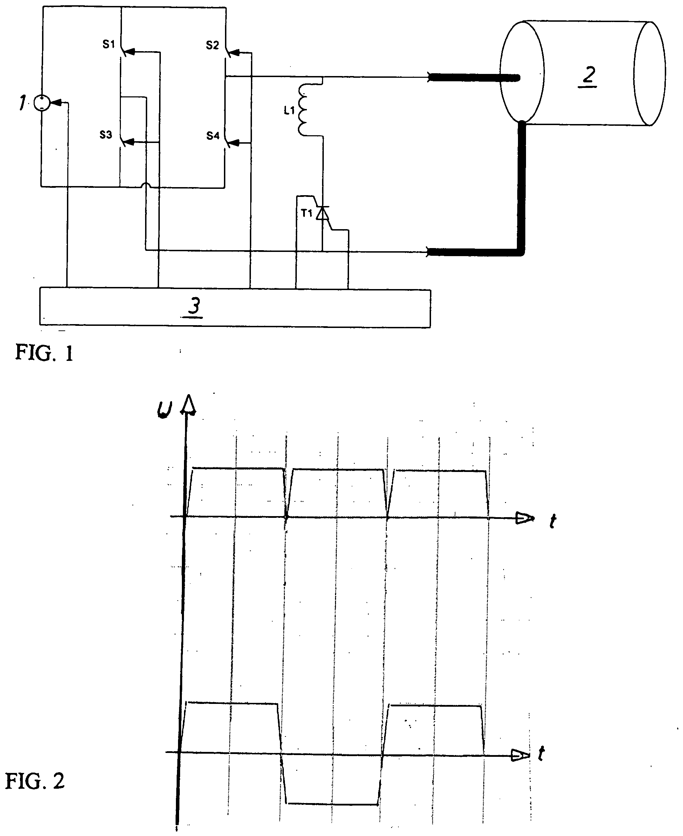

Die Prüfvorrichtung wird gemäß dem ersten Ausführungsbeispiel gemäß Fig. 1 durch eine Gleichspannungsquelle 1 gebildet, die durch Schaltelemente als Schalter S1, S2, S3, S4 in eine Brückenschaltung zur Umschaltung der Polarität mit einem zu überprüfenden Kabel 2 verbunden sind. Zusätzlich ist eine Drossel LI über ein Schaltelement TI als bipolarer Halbleiterschalter parallel einschaltbar.

Über eine zugeordnete Mess- und Steuereinheit 3 sind jeweils zwei Schalter S1 und S4 oder die Schalter S2 und S3 zur Umschaltung der Polarität der Gleichspannungsquelle 1 ansteuerbar.

Bei geringen kapazitiven Lasten durch kurze Kabel erfolgt eine direkte Speisung des Kabels 2 durch die Gleichspannungsquelle 1 über die Schalter S1 - S4. Der bipolare Halbleiterschalter TI ist in dieser Betriebsart passiv.

Sind Kabel 2 mit einer höheren Kapazität zu prüfen, bei denen durch die begrenzte Leistung der Gleichspannungsquelle das du/dt einen definierten Anstieg unterschreitet, sich somit die Spannungsform einem Dreieck annähert, wird dies durch die Mess- /Steuerungseinheit 3 erkannt und es erfolgt kein Laden/Entladen des Prüflings mehr. Der Umpolvorgang erfolgt über die Bauelemente als Drossel LI und Schaltelement TI. Hierbei tritt die Drossel LI als Energiespeicher auf, welche nach erfolgtem Umschwingen die Spannung mit einer Phasendrehung von 180° erneut in den Prüfling einspeist. Im Anschluss erfolgt ein Schließen der entsprechenden Schalter S1 - S4 und eine Kompensation der während des Umschwingvorganges aufgetretenen Verluste durch die Gleichstromquelle 1.

Vorteil dieser Anordnung ist, dass aus einer unipolaren Gleichspannungsquelle eine bipolare Wechselspannung generiert wird.

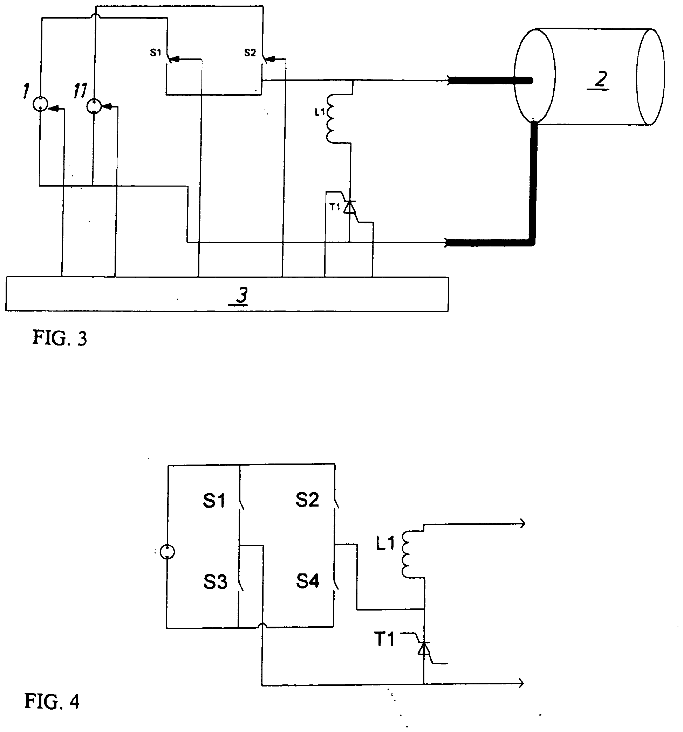

Eine gleichartige Ausbildung ist im weiteren Ausführungsbeispiel gemäß Fig. 3 mit zwei parallelen Gleichstromquellen 1, 11 gezeigt, wobei die unterschiedlichen Polaritäten über die Schalter S1 und S2 mit dem Kabel 2 verbindbar sind.

## Patentansprüche

1. Prüfvorrichtung von Kabeln (2) mit einer VLF-Spannung zur Generierung einer kosinus-rechteckförmigen Prüfspannung, wobei beim Prüfen eine Gleichspannungsquelle (1) das Kabel (2) auf eine Spannung auflädt und das geladene Kabel (2) über steuerbare Schaltelemente auf eine Gegenpolarität umschwingt sowie in einer weiteren Schaltstellung das Kabel (2) auf die ursprüngliche Polarität zurückschwingt, **dadurch gekennzeichnet, dass**
- die Schaltelemente durch Schalter (S1, S2, S3, S4) einer Brückenschaltung gebildet sind und
- jeweils ein Schalter (S1 und S4 oder S2 und S3) eines jeweiligen Brückenzweiges über eine Mess- und Steuereinheit (3) zur Umschaltung der Polarität am Kabel (2) dient,
- sowie über die Mess- und Steuereinheit (3) bei einer Umschaltung nach einer Halbwelle bei Unterschreitung eines definierten Anstieges der Spannung (u), du/dt, über ein weiteres gesteuertes Schaltelement (TI) eine zugeordnete Drossel (LI) als Energiespeicher parallel zur Gleichspannungsquelle (1) zuschaltet.

2. Prüfvorrichtung von Kabeln (2) mit einer VLF-Spannung zur Generierung einer kosinus-rechteckförmigen Prüfspannung, wobei beim Prüfen eine Gleichspannungsquelle das Kabel (2) auf eine Spannung auflädt und das geladene Kabel (2) über steuerbare Schaltelemente auf eine Gegenpolarität umschwingt sowie in einer weiteren Schaltstellung das Kabel (2) auf die ursprüngliche Polarität zurückschwingt, **dadurch gekennzeichnet, dass**
- die Gleichspannungsquelle durch zwei getrennte Gleichspannungsquellen (1, 11) zur Aufladung des Kabels (2) jeweils durch eine positive oder negative Gleichspannung gebildet ist,
- wobei über zwei parallel angeordnete Schalter (S1, S2) über eine Mess- und Steuereinheit (3) eine Umschaltung der Polarität am Kabel (2) durch Wechsel der Gleichspannungsquelle (1 oder 11) erfolgt,
- sowie über die Mess- und steuereinheit (3) bei einer Umschaltung nach einer Halbwelle bei Unterschreitung eines definierten Anstieges der Spannung(u), du/dt, über ein weiteres gesteuertes Schaltelement (TI) eine zugeordnete Drossel (LI) als Energiespeicher parallel zur Gleichspannungsquelle (1, 11) zuschaltet.

3. Prüfvorrichtung nach Anspruch 1 oder 2, **dadurch gekennzeichnet, dass** das weitere Schaltelement (TI) als bipolarer Halbleiterschalter ausgebildet ist.

## Claims

1. A testing device for cables (2) having a VLF voltage for generating a cosine square-wave test voltage, a direct current voltage source (1) charging the cable (2) to a voltage during testing and the charged cable (2) reversing to an opposite polarity via controllable switching elements and in a further switch position, the cable (2) reversing back to the original polarity, **characterized in that**
- the switching elements are formed by switches (S1, S2, S3, S4) of a bridge circuit and
- a switch (S1 and S4 or S2 and S3) of each bridge branch is used via a measuring and control unit (3) to switch the polarity on the cable (2)
- and via the measuring and control unit (3) when switching after a half-wave, when the voltage (u), du/dt falls below a defined increase, via a further controlled switching element (TI), an assigned throttle (LI) switches on as an energy store parallel to the direct current voltage source (1).

2. A testing device for cables (2) having a VLF voltage for generating a cosine square-wave test voltage, a direct current voltage source charging the cable (2) to a voltage during testing and the charged cable (2) reversing to an opposite polarity via controllable switching elements and in a further switch position, the cable (2) reversing back to the original polarity, **characterized in that**
- the direct voltage source is formed by two separate direct voltage sources (1, 11) for charging the cable (2) in each case by a positive or negative direct voltage,
- wherein the polarity on the cable (2) is switched by changing the direct current voltage source (1 or 11) via two switches (S1, S2) arranged in parallel via a measuring and control unit (3),
- and via the measuring and control unit (3) when switching after a half-wave, when the voltage(u), du/dt falls below a defined increase, via a further controlled switching element (TI), an assigned throttle (LI) switches on as an energy store parallel to the direct current voltage source (1, 11) .

3. The testing device according to claim 1 or 2, **characterized in that** the further switching element (TI) is designed as a bipolar semiconductor switch.

## Revendications

1. Dispositif de contrôle de câbles (2) avec une tension TBF pour générer une tension de contrôle cosinusorectangulaire, sachant que lors du contrôle, une source de tension continue charge le câble (2) à une tension et inverse le câble chargé (2) à une polarité opposée par le biais d'éléments de commutation pouvant être commandés et rebalance le câble (2) à la polarité originale dans une autre position de commutation, **caractérisé en ce que**
- les éléments de commutation sont formés par des commutateurs (S1, S2, S3, S4) d'un montage en pont et
- à chaque fois un commutateur (S1 et S4 ou S2 et S3) d'une branche de pont respective sert à la permutation de la polarité sur le câble (2) par le biais d'une unité de mesure et de commande (3),
- et connecte une bobine de réactance affectée (LI) en tant qu'accumulateur d'énergie parallèlement à la source de tension continue (1) par le biais de l'unité de mesure et de commande (3) lors d'une permutation après une alternance lors du dépassement inférieure d'une hausse définie de tension (u), du/dt, par le biais d'un autre élément de commutation commandé (TI).

2. Dispositif de contrôle de câbles (2) avec une tension TBF pour générer une tension de contrôle cosinusorectangulaire, sachant que lors du contrôle, une source de tension continue charge le câble (2) à une tension et inverse le câble chargé (2) à une polarité opposée par le biais d'éléments de commutation pouvant être commandés et rebalance le câble (2) à la polarité originale dans une autre position de commutation, **caractérisé en ce que**
- la source de tension continue est formée par deux sources de tension continue séparées (1, 11) pour charger le câble (2) respectivement par une tension continue positive ou négative,
- sachant qu'une permutation de la polarité sur le câble (2) a lieu par le biais d'une unité de mesure et de commande (3) par changement de la source de tension continue (1 ou 11) par deux commutateurs (S1, S2) montés en parallèle,
- et connecte une bobine de réactance affectée (LI) en tant qu'accumulateur d'énergie parallèlement à la source de tension continue (1, 11) par l'unité de mesure et de commande (3) lors d'une permutation après une alternance lors du dépassement inférieure d'une hausse définie de tension (u), du/dt, par le biais d'un autre élément de commutation commandé (TI).

3. Dispositif de contrôle selon la revendication 1 ou 2, **caractérisé en ce que** l'autre élément de commutation (TI) est constitué sous la forme d'un commutateur à semi-conducteurs bipolaire.
